# EUROPEAN PATENT APPLICATION

(11) **EP 4 156 284 A1**
(43) Date of publication of application: **29.03.2023**
(21) Application number: 22197181.5
(22) Date of filing: 22.09.2022
(51) Int. Cl.: H01L 29/06, H01L 27/088, H01L 29/66, H01L 29/775, B82Y 10/00

(54) **NANOSHEET TRANSISTORS HAVING A SINGLE-SIDED GATE**

(30) Priority: 24.09.2021 US 202117485158
(71) Applicant: INTEL Corporation, Santa Clara, CA 95054 (US)
(72) Inventor: CEA, Stephen, Hillsboro, 97124 (US); GUHA, Biswajeet, Hillsboro, 97124 (US); GULER, Leonard, Hillsboro, 97124 (US); GHANI, Tahir, Portland, 97229 (US); MA, Sean, Portland, 97221 (US)
(74) Representative: 2SPL Patentanwälte PartG mbB

(57) **Abstract**

Single-sided nanosheet transistor / Forksheet structures comprising an upper channel material (306C) over a lower channel material (306B). A first dielectric material (625) is formed adjacent to a first sidewall of the upper and lower channel materials. A second dielectric material (opposite 625) is formed adjacent, but not directly adjacent, to a second sidewall of the upper and lower channel materials. The first sidewall of the upper and lower channel materials is exposed by etching at least a portion of the first dielectric material. A sidewall portion of the second dielectric material may be exposed by removing sacrificial material from between the upper and lower channel materials. A single-sided gate stack (910) may then be formed in direct contact with the first sidewall of the upper and lower channel materials, and in contact with the sidewall portion of the second dielectric material. A further dielectric (425) may be present between the bases of adjacent fins..

## Description

### BACKGROUND

Device density in integrated circuits (ICs) continues to increase. Within the shrinking device footprint, vertical transistor orientations have become important. For example, vertically oriented transistor architectures based on nanosheet transistor stacks are becoming the basic transistor cell design of an IC. The number of channel layers within a semiconductor material stack and the lateral width of each channel layer may set the current carrying width of a nanosheet transistor.

A nanosheet transistor with a smaller lateral width may be referred to as a nanowire transistor while a nanosheet transistor with a larger lateral width may be referred to as a nanoribbon transistor. Nanoribbon and nanowire transistors are typically gate-all-around (GAA) transistors where the gate stack wraps completely around the channel semiconductor material. However, fully encompassing the channel material according to GAA architectures dictates a certain minimum lateral spacing between adjacent semiconductor channel stacks, for example to accommodate and an end cap of the gate electrode on both opposite sidewalls of the channel semiconductor material stacks. The transistor footprint may be reduced if the gate electrode and/or source/drain contact metal is only on one side of the stack of channel material nanosheets. Such "single-sided" nanosheet transistor architectures, and associated techniques for their fabrication, are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements. In the figures:
FIG. 1 is a flow diagram illustrating methods of fabricating nanosheet transistors with single-sided a gate stack, in accordance with some embodiments;
FIG. 2 is a flow diagram illustrating methods of fabricating nanosheet transistors with single-sided a source/drain contact, in accordance with some embodiments;
FIG. 3A, 4A, 5A, 6A, 7A, 8A and 9A are plan views of nanosheet transistor structures evolving as operations in the methods illustrated in FIG. 1 are practiced in accordance with some embodiments;
FIG. 3B, 4B, 5B, 6B, 7B, 8B and 9B are cross-sectional views of nanosheet transistor structures evolving as operations in the methods illustrated in FIG. 1 are practiced in accordance with some embodiments;
FIG. 10A, 10B, 11A, 11B and 12 are cross-section views of nanosheet transistor structures in accordance with some further embodiments;

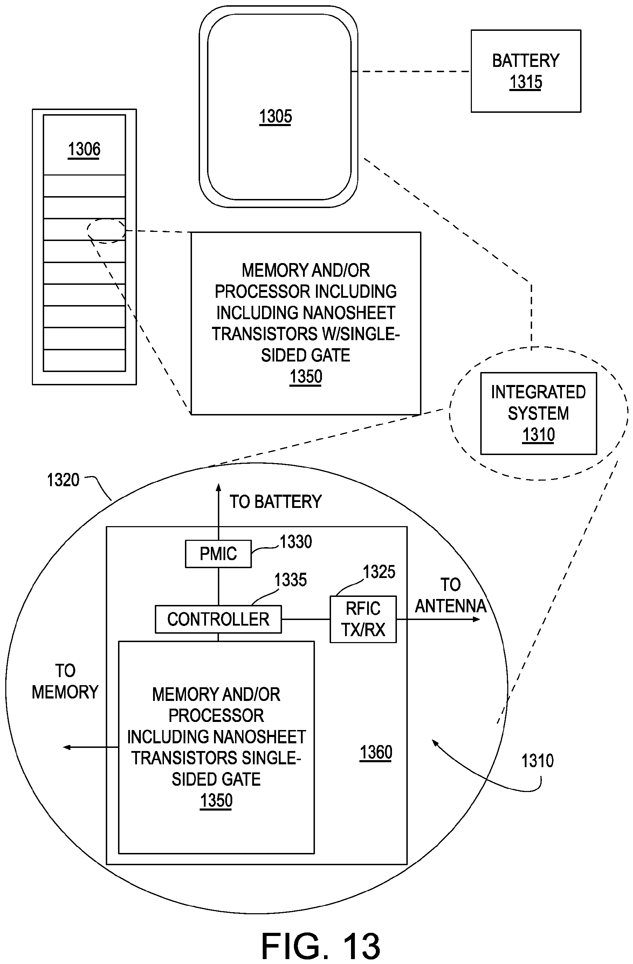

FIG. 13 illustrates a mobile computing platform and a data server machine employing an IC including single-sided nanosheet transistors, in accordance with some embodiments; and
FIG. 14 is a functional block diagram of an electronic computing device, in accordance with some embodiments.

### DETAILED DESCRIPTION

One or more embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" or "some embodiments" means that a particular feature, structure, function, or characteristic described in connection with the embodiment is included in at least one embodiment of the invention. Thus, the appearances of the phrase "in an embodiment" or "in one embodiment" or "some embodiments" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example. in the context of materials, one material or material over or under another may be directly in contact or may have one or more intervening materials. Moreover, one material between two materials may be directly in contact with the two materials or may have one or more intervening materials. In contrast, a first material "on" a second material is in direct contact with that second material. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

As used herein, the qualifier "substantially" is employed in the recognition that manufacturing processes output a population characterized by some distribution statistics. Unless explicitly stated otherwise, no more than incidental variation is to be expected between two things that are substantially the same. According, any quantifiable differences would be less than 10 %.

Methods and architectures associated with single-sided gate electrodes, source and/or drains, or source/drain contact metal of a stacked nanosheet transistor structure are described below. The architectures and fabrication techniques described are applicable both to nanosheet structures where all transistors structures within the stack are of a single conductivity type (e.g., all P-type or all N-type) and to nanosheet structures where one transistor structure is of a first conductivity type (e.g., P-type) and another transistor structure within the stack is of a complementary conductivity type (e.g., N-type).

In some examples, single-sided nanosheet transistors comprise a gate electrode that wraps around only one sidewall of each nanosheet channel semiconductor material, for example, to define a three-sided or "tri-gate" transistor channel. In some other embodiments, single-sided nanosheet transistor structures include single-sided source and/or drain semiconductor. In some other embodiments, single-sided nanosheet transistor structures include single-sided source contact metal and/or drain contact metal structures. In still other embodiments, single-sided nanosheet transistor structures include two or more of a single-side gate electrode, single-sided source and/or drain semiconductor structures or source contact metal and/or drain contact metal structures. Some such embodiments may advantageously enable the reduction of a nanosheet transistor standard circuit cell height. For example, the static random access (SRAM) cell height may be reduced relative to that where nanosheet transistors have a GAA architecture.

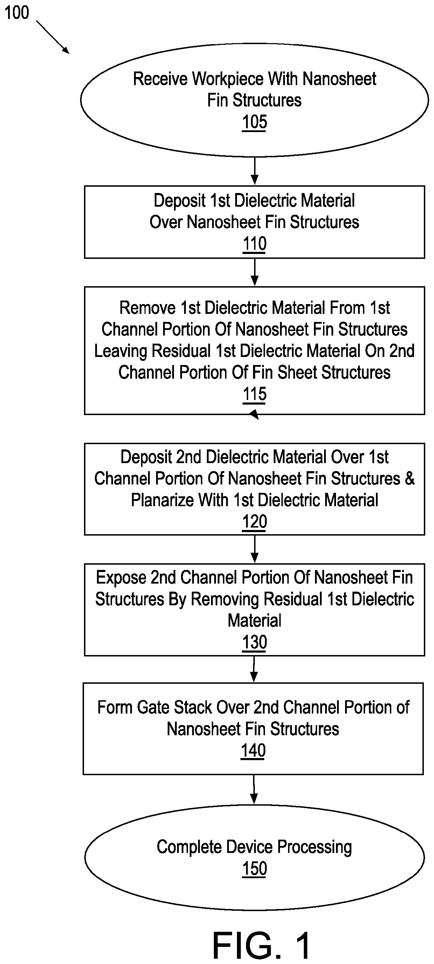

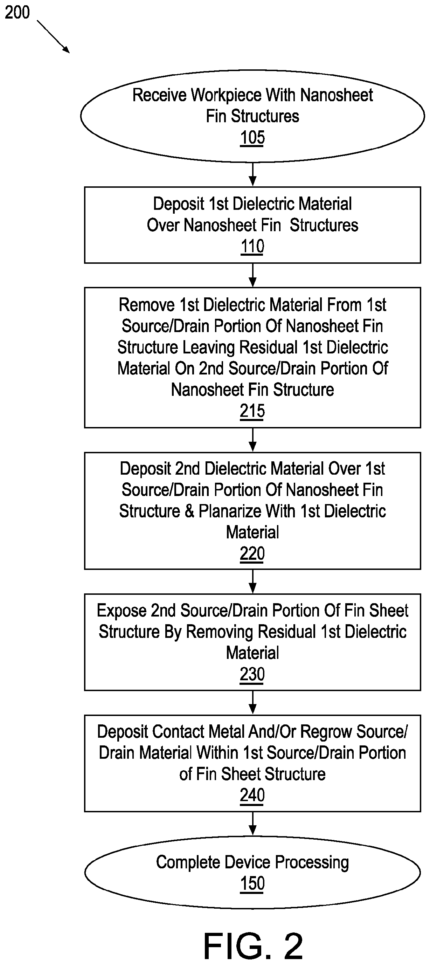

As described further below, a first dielectric material is deposited over nanosheet fin structures. The first dielectric material is then patterned, either with a self-aligned etch process, or with masked etch process, so as to be retained only along one side of the nanosheet fin structure. A second dielectric material is deposited and either the first or second dielectric material may then be selectively replaced with any of gate electrode material, source/drain semiconductor material, or source/drain contact material. FIG. 1 is a flow diagram illustrating methods 100 for fabricating nanosheet transistors with a single-sided gate stack, in accordance with some embodiments. FIG. 2 is a flow diagram illustrating methods 200 for fabricating nanosheet transistors with single-sided source/drain contact metal, in accordance with some embodiments.

Referring first to FIG. 1, methods 100 begin at input 105 where a workpiece including nanosheet fin structures is received. The workpiece may be any known to be suitable for IC manufacture. In some such embodiments, the workpiece received at operation 105 includes a crystalline semiconductor substrate, such as but not limited to, a monocrystalline silicon wafer (e.g., 300-400 mm diameter). The workpiece received at input 105 further includes fin structures comprising a stack of materials that include nanosheets of semiconductor material that are to become the channels of a transistor.

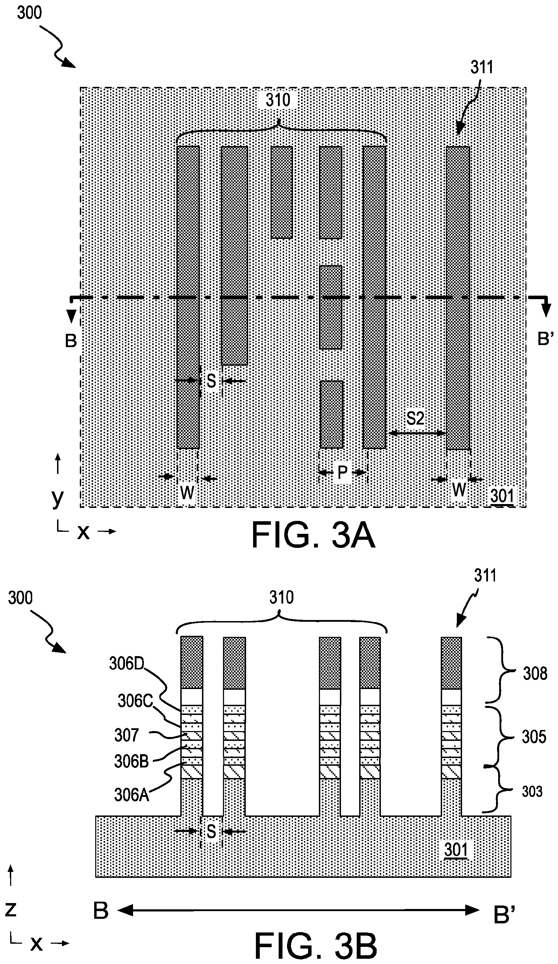

FIG. 3A is a plan view of an exemplary integrated circuit structure 300 that may be received at input 105. FIG. 3B is a cross-sectional view of integrated circuit structure 300 along the B-B' line also shown in FIG. 3A, in accordance with some embodiments. As illustrated in FIG. 3A-3B, nanosheet fin structures 310 and 311 include nanosheet bilayers 305 comprising sacrificial material 307 between channel semiconductor material nanosheets 306A, 306B, 306C and 306D. Although four channel nanosheets 306A-306D are specifically illustrated, a nanosheet fin structure may have any number of channel nanosheets separated by one or more layers of sacrificial material.

In some exemplary embodiments, channel nanosheets 306 are crystalline semiconductor. Although crystalline semiconductor includes polycrystalline thin film material, crystalline semiconductor may be advantageously monocrystalline. In some such embodiments, the crystallinity of channel nanosheets 306 is cubic with the top surfaces having crystallographic orientation of (100), (111), or (110), for example. Other crystallographic orientations are also possible. In some embodiments, channel nanosheets 306 are a substantially monocrystalline group IV semiconductor material, such as, but not limited to substantially pure silicon (e.g., having only trace impurities), silicon alloys (e.g., SiGe), or substantially pure germanium (e.g., having only trace impurities). Channel nanosheets 306 may also have any of these same exemplary compositions in alternative polycrystalline or amorphous embodiments, for example where channel nanosheets 306 comprise a thin film semiconductor material layer. Polycrystalline or amorphous embodiments of channel nanosheets 306 may also comprise semiconducting metal oxides, such as IGZO, for example.

Channel nanosheets 306 may also be a Group III-V binary, ternary or quaternary semiconductor alloys (e.g., having a first sub-lattice of at least one element from Group III of the periodic table, such as Al, Ga, or In, and a second sub-lattice of at least one element from Group V of the periodic table, such as P, As or Sb). In other embodiments, channel nanosheets 306 include one or more layers of a Group III-N binary, ternary or quaternary semiconductor alloy (e.g., GaN, AlGaN, InAlGaN). Group II-VI semiconductor alloys are also possible, as are transition metal chalcogenides (TMD).

Sacrificial material 307 may have any composition sufficiently distinct from that of channel nanosheets 306A-D to facilitate their subsequent selective removal. In some embodiments, where channel nanosheets 306 are a Group IV semiconductor material, sacrificial material 307 includes more germanium than channel nanosheets 306. For example, where the channel nanosheets 306A-D are predominantly silicon, sacrificial layers are Si₁₋ₓGe_{X}, where X is between 0.15-0.6.

The nanosheet fin structures may further include one or more base or buffer material layers 303 below the nanosheets. Base or buffer material layers 303 may be of any composition and may, for example, have a higher concentration of P-type or N-type impurities than channel nanosheets 306A-D. Nanosheet fin structures 310, 311 may extend into a bulk semiconductor substrate 301, such as monocrystalline silicon, with a portion of base material layers 303 then having the substantially the same composition and/or crystallinity as substrate 301.

Nanosheet fin structures 310 and 311 may further include one or more layers of cap dielectric material 308, which may for example function as a fin hardmask. Cap dielectric material 308 may be of any material suitable with some exemplary materials including silicon oxides (SiO), silicon nitrides (SiN), silicon carbides, (SiC), or carbon-doped oxides (SiOC(H)).

Nanosheet fin structures 310 and 311 may have been defined using any suitable techniques. For example, one or more lithographic processes (e.g., extreme UV) and/or subtractive processes (e.g., hardmask etching) and/or additive processes (e.g., thin film deposition) may have been practice upstream of methods 100 (FIG. 1). In some embodiments, the nanosheet fin structures 310, 311 are generated by a multi-patterning processes, such as, but not limited to, pitch-quartering. Such techniques may achieve a target minimum lateral width W (FIG. 3A) of 15 nm, or less, for example. Lateral spacing S between these nanosheet fin structures may be more or less than the target lateral width W to achieve any desired fin structure pitch P.

In some embodiments, the nanosheet fin structures received at operation 105 (FIG. 1) may be separated into two or more populations. In the example illustrated FIG. 3A and 3B, nanosheet fin structures 310 have a lateral width W and are spaced apart by a minimum lateral spacing S that is no more than a threshold distance or spacing. Nanosheet fin structures 311 also have lateral width W, but are spaced apart from adjacent mask structures by a spacing S2, which is greater than the threshold distance of spacing S. Although the threshold spacing may vary with implementation, in some exemplary embodiments the threshold spacing is 5-15 nm. Nanosheet fin structures 311 may also have a lateral width different than W (e.g., larger or smaller than W).

Returning to FIG. 1, methods 100 continue at block 110 where a dielectric material layer is conformally deposited as a liner over the nanosheet fin structures. Any deposition process providing sufficient conformality of the layer thickness may be practiced at block 110. Deposition of the dielectric liner may be by chemical and/or atomic layer deposition (ALD), for example. A conformal process ensures the thickness of the dielectric material layer along a sidewall of the nanosheet fin structures is approximately equal to the thickness of the cap layer within spaces between the nanosheet fin structures that exceed the threshold spacing S.

Depending on the spacing between adjacent nanosheet fin structures, and the thickness of the dielectric material deposited at block 110, spacing between two adjacent fins may be completely filled, or not. In some exemplary embodiments where the thickness of the dielectric material layer adjacent to the sidewalls of the fin structures is at least one-half the spacing S, spaces between the fin structures that are less than or equal to spacing S will be occupied by a dielectric material liner that traverses adjacent sidewalls of multiple nanosheet fin structures. Where the thickness of the dielectric material layer is sufficient, the dielectric material layer surface closes onto itself within the spacing S. For spaces between adjacent fin structures that exceed spacing S, the cap layer may not close onto itself and at least a portion of the underlying substrate will be covered by only the nominal dielectric material layer thickness. Such fin spacing dependent dielectric backfill may be relied upon for self-aligned processing, or not. Regardless, a masking material may be formed over the dielectric material deposited at block 110 to further define portions or regions of the dielectric material deposited at block 110 that are to be retained.

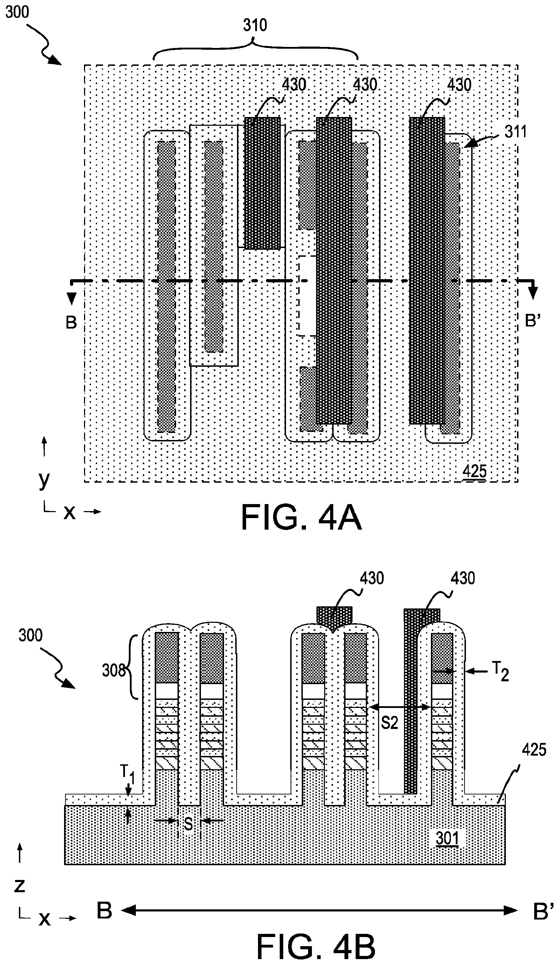

FIG. 4A and 4B further illustrate an exemplary dielectric material 425, which may have any material composition suitable for subsequent etch processes. In some examples, dielectric material 425 is one or more layer of a silicon oxide (SiO), silicon oxynitride (SiON), silicon nitride (SiN), silicon carbide, (SiC), or carbon-doped oxide (SiOC(H)). In some advantageous embodiments, dielectric material 425 has a different chemical composition than a top layer of cap dielectric material 308. In one specific example, dielectric material 425 is SiO (e.g., SiO₂). As illustrated, dielectric material 425 has a thickness T1 on planar regions of substrate 301, and a thickness T2 on sidewalls of nanosheet fin structures 310, 311. In exemplary embodiments, conformality of the dielectric deposition is such that thickness T2 is not less than 80% of thickness T1.

As further illustrated in FIG. 4A and 4B, mask features 430 are patterned over portions of dielectric material 425. As shown in FIG. 4A, mask features 430 run substantially parallel to the length (y-dimension) of the fin structures and overlap only a portion of the fin structure lateral width W. As one example, a mask feature 430 overlaps spacing S between a pair of closely spaced fin structures 310. In another example, an edge of a mask feature 430 and fin structure 311 is offset by at least thickness T2 on a first side of fin structure 311 and less than thickness T2 on a second, opposite side of fin structure 311. Mask feature 430 may be of any length (e.g., y-dimension), with some variations illustrated in FIG. 4A for clarity. FIG. 4A and 4B further illustrate how mask lines 430 are optional with no mask line 430 being present over space S between a pair of closely spaced nanosheet fin structures 310.

Returning to FIG. 1, methods 100 continue at block 115 where the dielectric material deposited at block 110 is removed from a first channel portion of the nanosheet fin structures while being retained as a residue over or on a second channel portion of the fin structures. In exemplary embodiments, the dielectric material layer is removed at block 115 with an etch that targets the nominal thickness of the layer (with suitable over etch) to expose surfaces of the workpiece that are covered with only the nominal dielectric material layer thickness. In exemplary embodiments, an isotropic etch is performed at block 115 for a duration sufficient to completely removed the dielectric material thickness from a sidewall of the nanosheet channel material. The isotropic etch may be a plasma based process, or a wet chemical etch, for example. As described further below, another (e.g., isolation) dielectric will be subsequently formed adjacent to the first channel portion that is exposed at block 115 while at least some amount of the dielectric material retained as residue at block 115 will be subsequently replaced with gate material.

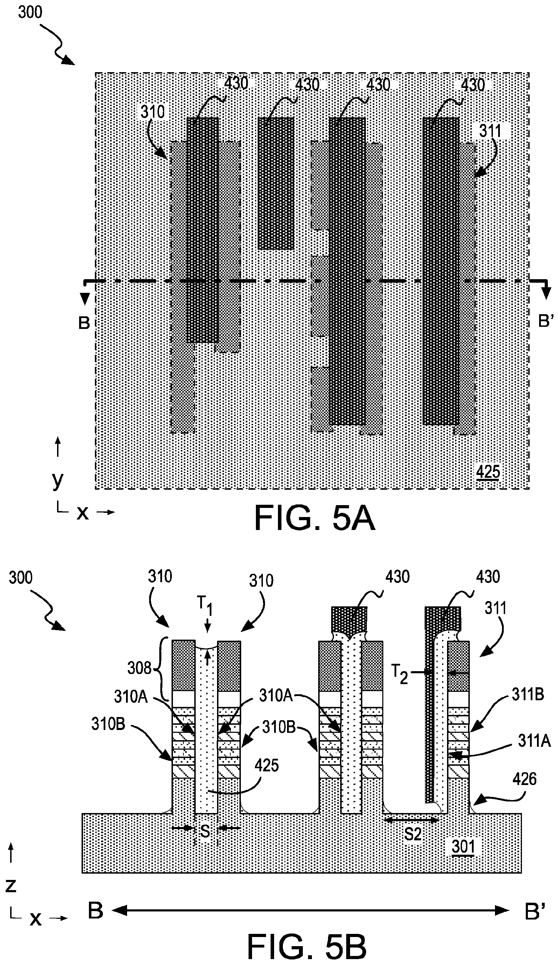

As further illustrated in FIG. 5A and 5B, dielectric material 425 has been isotropically removed, for example, with an NF₃ or SF₆ based downstream plasma etch. The isotropic etch removes at least thickness T1 from unmasked portions of dielectric material 425. In some embodiments where nanosheet fin structures 310 are separated by spacing S, dielectric material 425 remains on interior fin sidewalls 310A because the spacing S is completely filled with dielectric material 425. Hence, dielectric material 425 will remain adjacent to interior fin sidewalls 310A of any fin structures are that are in sufficient proximity. While dielectric material 425 within spacing S is only recessed by an amount (e.g., T1) less than a thickness of cap dielectric 308, the isotropic etch removes dielectric material 425 from exterior fin sidewalls 310B.

As further illustrated in FIG. 5B, a similar differentiation between fin sidewalls can be achieved for any fin spacing exceeding S where a mask feature 430 protects dielectric material 425 covering interior sidewalls 310A from the isotropic etch that removes unmasked dielectric material 425 from exterior sidewalls 310B. In further embodiments where a mask feature 430 is laterally offset from nanosheet fin structure 311, dielectric material 425 is retained over, or adjacent to, only one fin sidewall 311A with the isotropic etch exposing the another, opposite, fin sidewall 311B. Hence, a mask feature 430 may protect one side of a single fin structure or two sides of two adjacent fin structures. For example, in alternative embodiments dielectric material 425 within space S2 between nanosheet fin structure 310 and nanosheet fin structure 311 may be completely retained where the two mask features 430 are merged into a single mask feature spanning space S2.

Indicative of the isotropic etch, a residual dielectric material foot 426 remains at the base of exterior fin sidewalls 310B, below the channel semiconductor nanosheets. Lateral etch undercut below mask lines 430 is also indicative of etching dielectric material 425 isotropically in accordance with exemplary embodiments. Hence, while mask features 430 may be ephemeral, dielectric material residues may provide a lasting fingerprint of the fabrication process.

Returning to FIG. 1, methods 100 continue at block 120 where a second dielectric material is deposited over the nanosheet fin structures, contacting the channel portions that were exposed when the first dielectric material was removed. Elsewhere, the second dielectric material builds up over the residual first dielectric material retained adjacent to the channel portions of the nanosheet fin structures. The dielectric material deposited at block 120 may be any dielectric material suitable for electrical isolation between adjacent nanosheet fin structures. The dielectric material deposited at block 120 has a sufficiently different chemical composition than the dielectric material deposited at block 110 to provide adequate etch selectivity. After deposition, the dielectric material deposited at block 120 is then planarized, or otherwise recessed, to expose the dielectric material deposited at block 110.

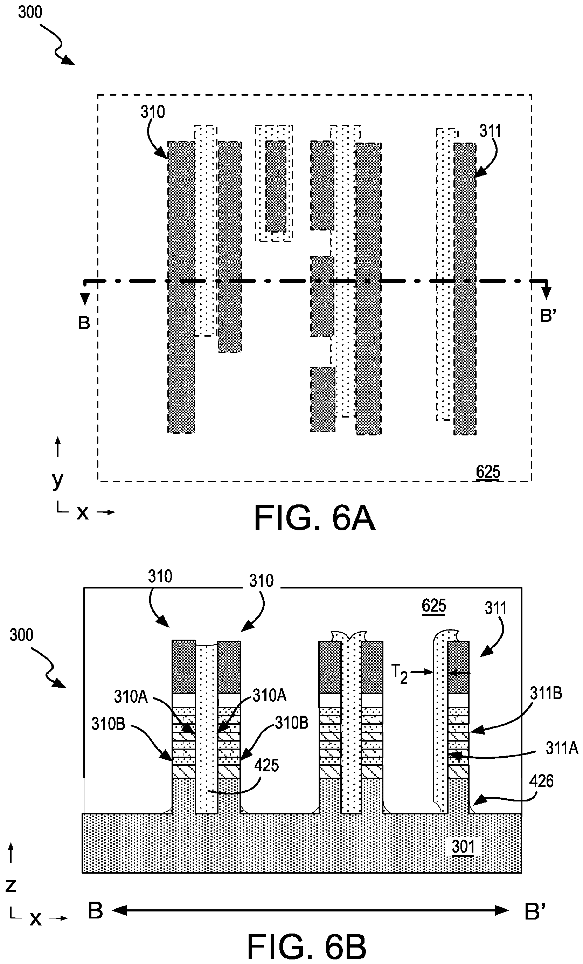

In the example illustrated in FIG. 6A and 6B, IC structure 300 has evolved to include a dielectric material 625. In some examples, dielectric material 625 is silicon oxide (SiO), silicon nitride (SiN), silicon oxynitride (SiON), silicon carbide, (SiC), or carbon-doped oxide (SiOC(H)). In exemplary embodiments where dielectric material 425 is SiO, dielectric material 625 is other than SiO (e.g., SiOC(H)). In other embodiments where dielectric material 425 is SiON, dielectric material 625 is SiO or SiOC(H). In other embodiments where dielectric material 425 is a first SiON, dielectric material 625 is a second SiON with different nitrogen content. Although dielectric material 625 is illustrated as being of a single homogenous composition, dielectric material 625 may also be multi-layered, for example with a first layer adjacent to a base of the fin structures and a second material adjacent to a top of the fin structures.

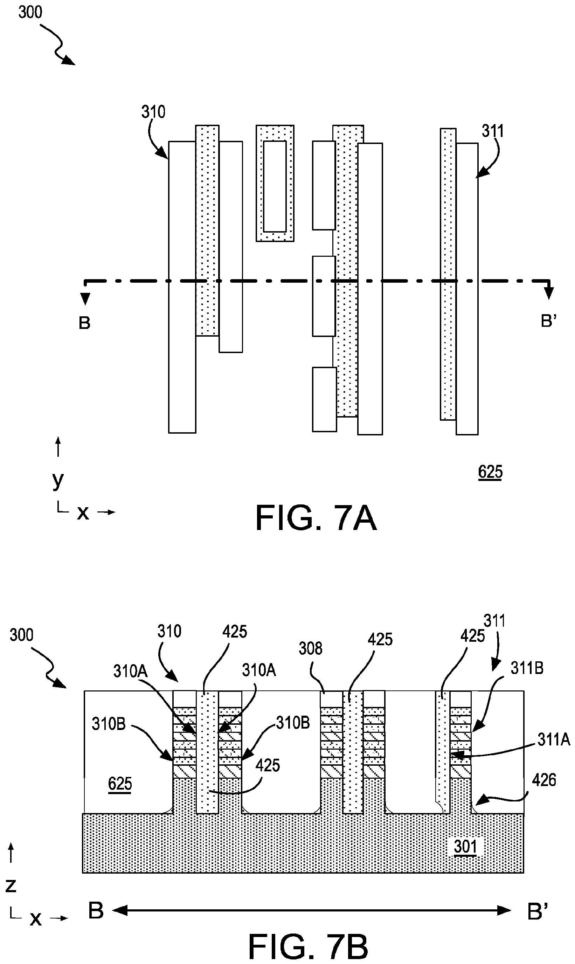

As further illustrated in FIG. 7A and 7B, dielectric material 625 (and/or separate layers thereof) are planarized and/or recessed by any suitable etch process to expose dielectric material 425 retained adjacent to interior fin sidewalls 310A. In this example, a dielectric planarization process is terminated when a bottom layer of dielectric cap 308 is exposed. Accordingly, dielectric material 625 remains adjacent to outer fin sidewalls 310B as well as adjacent to fin sidewall 311B.

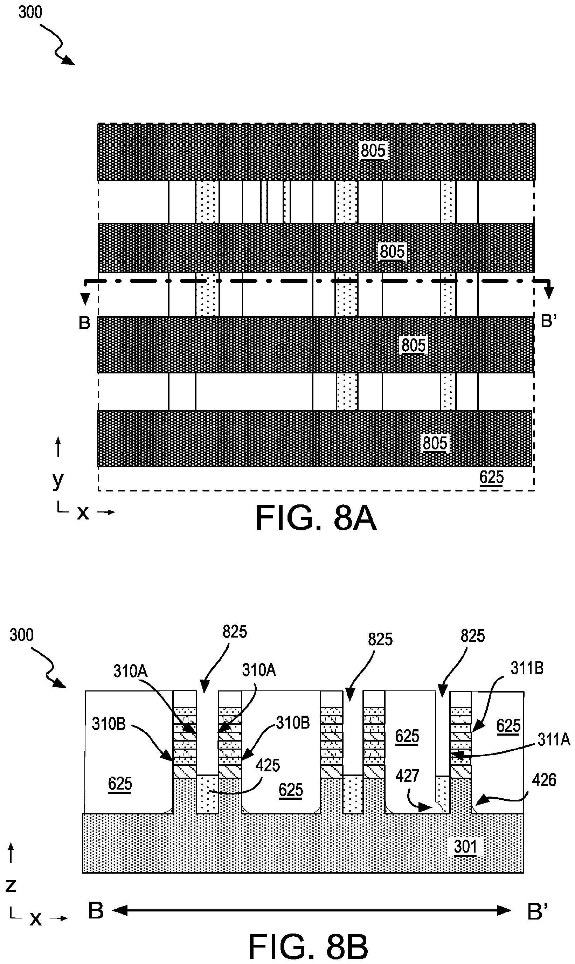

Returning to FIG. 1, methods 100 continue at block 130 where at least a portion of the residual dielectric material that was deposited at block 110 is removed to expose a channel portion of the nanosheet fin structures. Block 130 therefore may entail any etch process suitable for recessing the dielectric residue selectively over the other dielectric material deposited at block 120. In the example illustrated in FIG. 8A and 8B, a recess 825 is formed between adjacent nanosheet fin structures where dielectric material 425 is etched. As shown, dielectric material 425 is recessed below a lowest one of the channel semiconductor nanosheets with some residual dielectric material 425 remaining adjacent to the base of the fin structures. Recess 825 exposes interior sidewall 310A while exterior sidewalls 310B remain protected by dielectric material 625. Similarly, recess 825 exposes fin sidewall 311A while fin sidewall 311B remains protected by the laterally adjacent dielectric material 625. As shown in FIG. 8A, the dielectric etch process may be masked by mask features 805, which in this example run substantially orthogonal to the fin structures. Accordingly, the dielectric material deposited at block 110 may be retained along non-channel (e.g., source and drain) lengths of the nanosheet fin structures.

Returning to FIG. 1, methods 100 continue at block 150 where a gate stack is formed according to any suitable technique(s). Because the dielectric material deposited at block 120 is retained during the dielectric etch performed at block 130, the gate stack formed at block 140 is only formed on one sidewall of the nanosheet fin structures. Formation of the gate stack at block 140 may, for example, include an etch of the sacrificial material between separate channel nanosheets, deposition of a gate insulator (e.g., any conventional or high-k dielectric, ferroelectric, etc.), and deposition of one or more workfunction metals. Methods 100 then complete at output 150 where IC structures may be fabricated according to any other techniques. For example, back end of line (BEOL) metallization process may be practiced to electrically interconnect terminals of the nanosheet transistors into any functional circuit such as a system on chip (SOC), or any disintegrated logic unit.

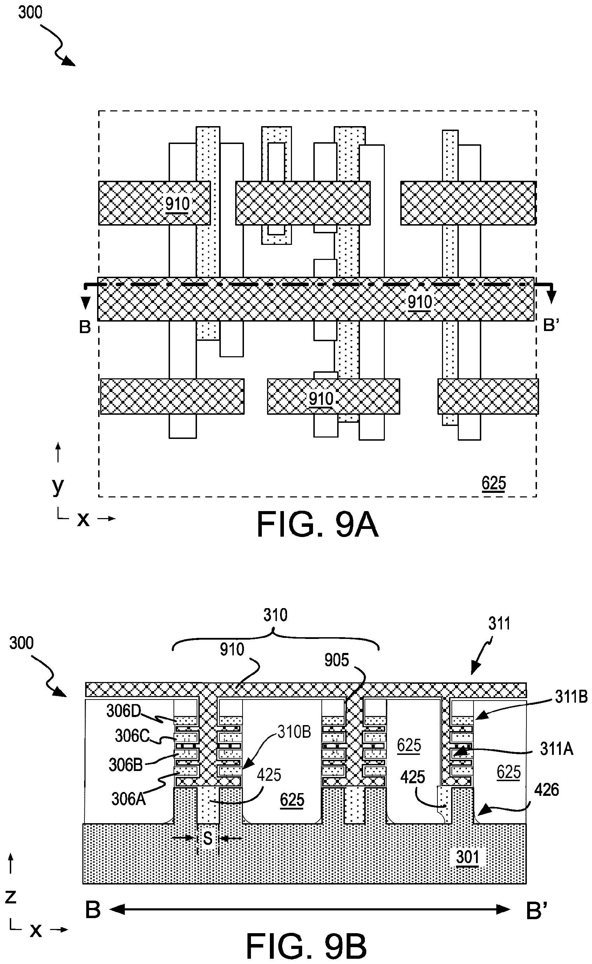

In the example further illustrated in FIG. 9A and 9B, sacrificial dielectric material between channel nanosheets 306A-306D has been removed by a selective etch process performed through recesses 825 (FIG. 8B). A gate insulator 905 is subsequently deposited on the exposed surfaces of channel nanosheets 306A-306D, followed by a gate electrode material 910 which may substantially backfill recesses 825. Since dielectric material 625 remains adjacent to fin sidewalls 310B and 311B, gate insulator 905 and gate electrode material 910 do not fully surround each channel nanosheet, instead forming a tri-gate type channel gating interface. With retention of dielectric material 625 along exterior sidewalls 310B, gate electrode material 910 has a tuning fork, or double-sided comb structure for embodiments where dielectric material 425 is the only material between two adjacent fin structures. For single fin structure 311, gate dielectric 905 and gate electrode 910 have a single-sided comb structure with their lateral thickness being no more than thickness T2 of dielectric material 425.

Gate insulator 905 may be any material suitable for a MOSFET, including ferroelectrics and dielectrics having a moderate bulk relative permittivity (e.g., k between 3.5 and 9) or having a high bulk permittivity (e.g., k greater than 9). For example, gate insulator 905 may include one or more of SiO and SiN. In other examples, gate insulator 905 may include one or more of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Gate electrode material 910 may include one or more layers. For example, a first gate electrode layer in contact with the gate insulator 905 may be a workfunction material while a second layer in contact with the first layer is a fill material. In some embodiments, gate electrode material 910 includes only an n-type workfunction metal, which may have a workfunction between about 3.9 eV and about 4.2 eV, for example. Suitable n-type work function metals include, but are not limited to, hafnium, zirconium, titanium, tantalum, aluminum, and metal carbides that include these elements (e.g., titanium carbide, zirconium carbide, tantalum carbide, hafnium carbide and aluminum carbide). In some other embodiments, gate electrode material includes only a p-type workfunction metal, which may have a workfunction between about 4.9 eV and about 5.2 eV, for example. Suitable p-type materials include, but are not limited to, ruthenium, palladium, platinum, cobalt, nickel titanium, tungsten, conductive metal nitrides (e.g., TiN, WN), and conductive metal oxides (e.g., ruthenium oxide). In still other embodiments, gate electrode material 910 may instead include only a mid-gap workfunction metal having a workfunction between those of the n-type and p-type workfunction metals (e.g., 4.2-4.9eV). Although not illustrated in FIG. 9A and 9B, a compositionally distinct gate fill metal may be over the workfunction metal where a thickness of the workfunction metal is insufficient to fully occupy recess 825 (FIG. 8B).

As introduce above, methods similar to methods 100 may be practiced to form single-sided source/drain semiconductor and/or source/drain contact metal by accessing only one sidewall of a nanosheet fin structure. Just as for a gate stack, such single-sided source/drain structures may reduce lateral spacing between adjacent fin structures relative to conventional structures.

FIG. 2 is a flow diagram illustrating methods 200 fabricating nanosheet transistors with single-sided source/drain contact, in accordance with some embodiments. Either of methods 100 or methods 200 may be practiced exclusively of the other. However, methods 200 may also be practiced in combination with methods 100. When combined, not all blocks illustrated in FIG. 1 need be practiced separately from the blocks illustrated in FIG. 2.

Methods 200 again begin at operation 105 where a workpiece is received. The workpiece may be any of those suitable for methods 100, as described above. The workpiece received at operation 105 again includes nanosheet fin structures, for example substantially as described above.

Methods 200 continue at block 110 where the first dielectric material is deposited over the nanosheet fin structures, for example substantially as described above in the context of methods 100. At block 215, the first dielectric material is removed from a first source/drain portion of the nanosheet fin structure, leaving residual dielectric material on a second source/drain portion of the nanosheet fin structure. In exemplary embodiments, the first source/drain portion includes a first sidewall of a nanosheet fin structure while the second source/drain portion incudes a second sidewall of the nanosheet fin structure, opposite the first sidewall. The etch process performed at block 215 may be substantially the same as that described for block 115 in methods 100 (FIG. 1), for example.

Methods 200 continue at block 220 where a second dialectic material is deposited over the first source/drain portion of the nanosheet fin structures that was exposed at block 215. The second dielectric material deposited at block 220 may be substantially the same as that deposited at block 120 (FIG. 1), for example. The second dielectric material is again planarized to expose a top of the first dielectric material, substantially as described above. Notably, where both methods 100 and 200 are combined blocks 215 and 220 may be performed concurrently with blocks 115 and 120, respectively.

At block 230, at least a portion of the first dielectric residue is removed selectively to the second dielectric material to expose the second source/drain portion of the nanosheet fin structure without exposing the first source/drain portion that remains protected by the second dielectric material. At block 240, the recess formed at block 230 is then at least partially backfilled with a regrown source/drain semiconductor and/or source/drain contact metal. For embodiments where methods 200 are combined with methods 100, blocks 230 and 240 may performed prior to formation of a gate stack and confined according to an etch mask that protects the channel region. Methods 200 complete at output 150, where an IC structure is completed, for example substantially as described above in the context of methods 100.

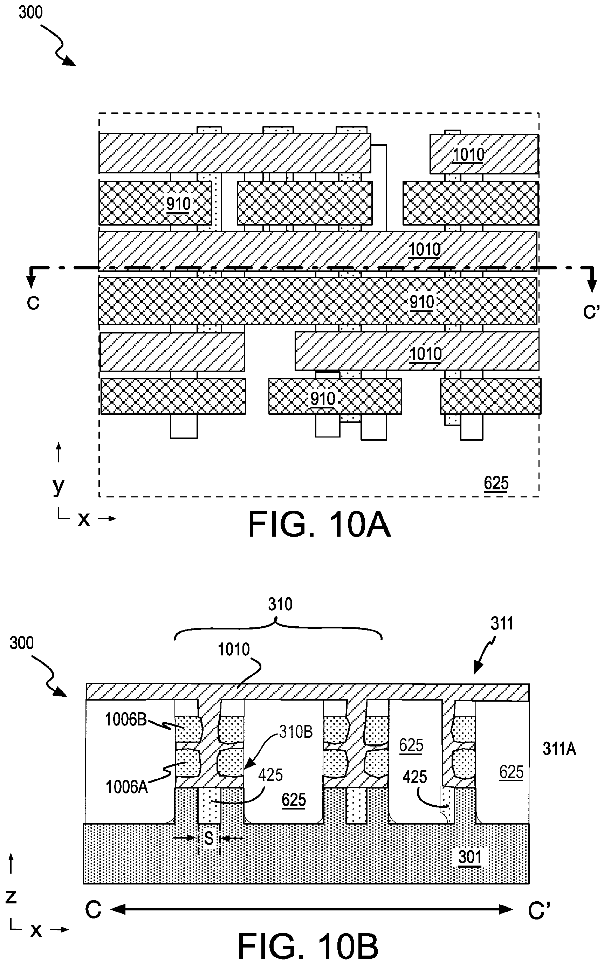

In the example illustrated in FIG. 10A, IC structure 300 includes both gate electrode material 910 over a channel portion of nanosheet fin structures and source/drain contact metal 1010 over source and/or drain portions of the nanosheet fin structures. Source/drain contact metal 1010 is advantageously single-sided, fabricated for example according to methods 200 (FIG. 2). In some embodiments, gate electrode material 910 is also single-sided, for example substantially as described above (e.g., in FIG. 9A, 9B). However, gate electrode material 910 may instead wrap completely around a channel regions of each nanosheet.

FIG. 10B illustrates a cross-sectional view of the source/drain region demarked by the c-c' line in FIG. 10A. As further shown in FIG. 10B, IC structure 300 includes source/drain semiconductor regions 1006A and 1006B contacted by source/drain contact metal 1010. Source/drain semiconductor region 1006A and 1006B may each comprise any semiconductor material suitable for a transistor. In some embodiments source/drain semiconductor regions 1006A and 1006B are impurity-doped semiconductor material. In the illustrated embodiment, source/drain semiconductor regions 1006A and 1006B include separate epitaxial semiconductor source/drain crystals, which may comprise one or more electrically active impurities. In some embodiments, for example, source/drain semiconductor regions 1006A and 1006B are a Group IV semiconductor material (e.g., Si, Ge, or SiGe alloy) with at least one of a p-type impurity (e.g., boron or gallium) or an n-type impurity (e.g., phosphorus, arsenic, or antimony).

Source/drain semiconductor regions 1006A and 1006B may be of the same conductivity type. However, in a stacked CMOS nanosheet transistor structure, source/drain semiconductor region 1006A may be p-type or n-type, while source/drain semiconductor region 1006B has a conductivity type complementary to that of 1006A. Although only two source/drain semiconductor regions are illustrated, for example where epitaxial regrowths from the four nanosheets illustrated in FIG. 3A-9B have merged together into fewer source/drain crystals (e.g., two of different conductivity type), there may be any number of source/drain semiconductor crystals.

As further illustrated in FIG. 10B, contact metal 1010 is in direct contact with an interior sidewall 310A of source/drain semiconductor regions 1006A and 1006B. Contact metal 1010 is single-sided since dielectric material 625 remains in contact with an exterior sidewall 310B of source/drain semiconductor regions 1006A and 1006B. In nanosheet fin structure 311, contact metal 1010 is similarly in contact with one sidewall 311A of the source/drain semiconductor regions while dielectric material 625 is in contact with the opposite sidewall 311B of the source/drain semiconductor regions. Contact metal 1010 may evolve to be single-sided substantially as described and depicted for a single-sided gate stack. For example, dielectric material 425 may be recessed selectively to dielectric material 625 to expose interior sidewalls 310A of nanosheet source/drain regions. Sacrificial material between the nanosheet source/drain regions may then be selectively removed. The source/drain regions of the nanosheets may also be removed, and source/drain semiconductor regions 1006A and 1006B regrown. Such source/drain regrowth may fully backfill the recess where dielectric material 425 was removed, or, as illustrated in FIG. 10B, contact metal 1010 may be deposited into any recess remaining after regrowth of source/drain semiconductor regions 1006A and 1006B.

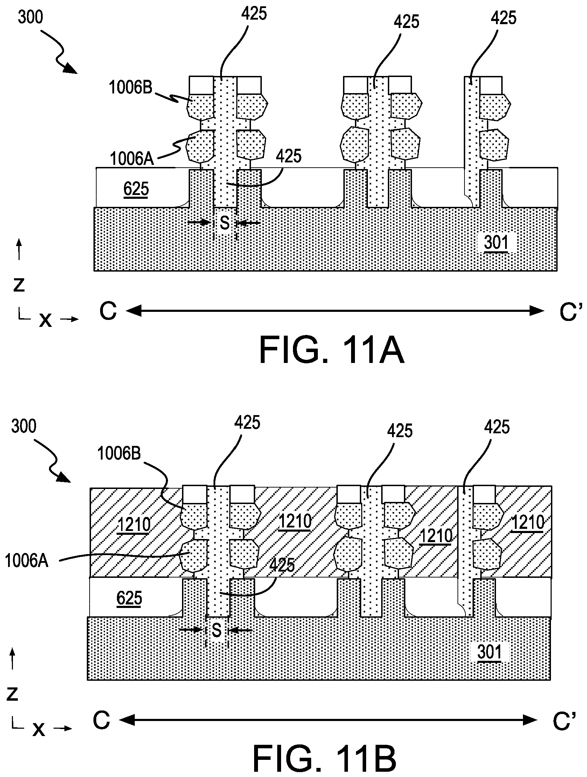

Notably, the differentiation in chemical composition of dielectric material 425 and dielectric material 625 may also facilitate source/drain contact metal that instead makes single-sided contact to sidewalls 310B and 311B. For example, as illustrated in FIG. 11A, instead of recess etching dielectric material 425, dielectric material 625 may be etched back selectively to dielectric material 425. This alternate recess etch exposes exterior sidewalls 310B of source/drain semiconductor regions 1006A and 1006B while dielectric material 425 remains adjacent to interior sidewalls 310A. For nanosheet fin structure 311, sidewall 311B is likewise exposed while dielectric material 425 remains adjacent to sidewall 311A.

FIG. 11B further illustrates IC structure 300 after deposition and planarization of a source/drain contact metal 1210. As shown, the alternate recession of dielectric material 625 may facilitate an alternate electrical interconnection between adjacent nanosheet fin structures. For example, unlike source/drain contact metal 1010 (FIG. 10B), source/drain contact metal 1210 does not place nanosheet fins 310 separated by spacing S into electrical parallel. Source/drain contact metal 1210 instead electrically couples together nanosheet fins 310 that are separated by more than the spacing S.

The differing chemical composition of dielectric material 425 and dielectric material 625 may also facilitate multiple instances of source/drain contact metal, some which may make single-sided contact to sidewalls 310A and 311A while others make single-sided contact to sidewalls 310B and 311B. In general, the two single-sided source/drain contact metal structures illustrated by FIG. 10B and 11B may be fabricated iteratively with each type of source/drain contact metal structure to make contact to only some of the source/drain semiconductor regions of a nanosheet fin. For example, a first contact metal may make single-sided contact to one or more lower nanosheets of a nanosheet fin while a second contact metal may make single-sided contact to one or more upper nanosheets of the same nanosheet fin.

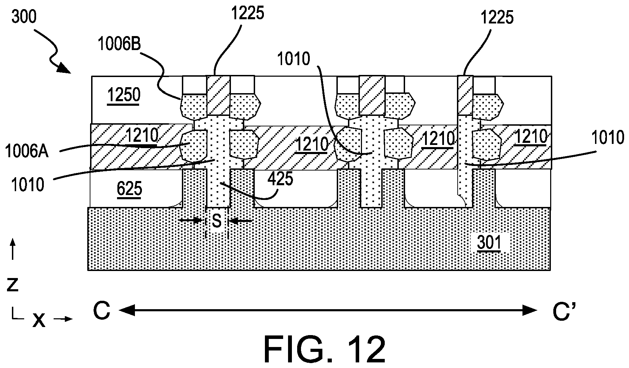

In the example illustrated in FIG. 12, during a first recess etch process dielectric material 625 is etched back selectively to dielectric material 425. This first recess etch exposes exterior sidewalls 310B of source/drain semiconductor regions 1006A and 1006B while dielectric material 425 remains adjacent to interior sidewalls 310A. Contact metallization 1210 is then deposited and planarized substantially as described above. Additionally, following planarization, contact metal 1210 is recess etched to expose again exterior sidewalls 310B of source/drain semiconductor region 1006B. A dielectric material 1225 (which may have the same composition as dielectric material 625) is then deposited over contact metal 1210 and planarized with dielectric material 425 between the nanosheet fin structures.

During a second recess etch process dielectric material 425 is etched back selectively to dielectric material 1225. This second recess etch is of lesser depth and exposes interior sidewalls 310A of only source/drain semiconductor region 1006B. A second recess is then backfilled with contact metal 1010 to arrive at the IC structure 300, substantially as depicted in FIG. 12. For nanosheet fin structure 311, sidewall 311B is likewise exposed while dielectric material 425 remains adjacent to sidewall 311A. The multi-contact structure illustrated in FIG. 12 may, for example, be advantageous for CMOS nanosheet fins where source/drain semiconductor region 1006A is of a conductivity type complementary to that of source/drain semiconductor region 1006B, and the two transistor source/drain terminals are to be at different circuit nodes.

In view of the above description, it will be appreciated that the technique of forming single-sided nanosheet transistors to dimensionally scale geometries may be readily applied to any IC chip. FIG. 18 illustrates a mobile computing platform and a data server machine employing an IC chip including single-sided nanosheet transistor, for example as described elsewhere herein. The server machine 1306 may be any commercial server, for example including any number of high-performance computing platforms disposed within a rack and networked together for electronic data processing. The mobile computing platform 1305 may be any portable device configured for each of electronic data display, electronic data processing, wireless electronic data transmission, or the like. For example, the mobile computing platform 1305 may be any of a tablet, a smart phone, laptop computer, etc., and may include a display screen (e.g., a capacitive, inductive, resistive, or optical touchscreen), a chip-level or package-level integrated system 1310, and a battery 1315.

Either disposed within the integrated system 1310 illustrated in the expanded view 1320, or as a stand-alone packaged chip within the server machine 1306, one or more IC chips includes a memory circuitry block (e.g., RAM), a processor circuitry block (e.g., a microprocessor, a multi-core microprocessor, graphics processor, or the like), either or both of which include single-sided nanosheet transistors, for example in accordance with embodiments described herein. An IC chip 1350 may be further coupled to a board, a substrate, or an interposer 1360 along with, one or more of a power management integrated circuit (PMIC) 1330, RF (wireless) integrated circuit (RFIC) 1325 including a wideband RF (wireless) transmitter and/or receiver (TX/RX) (e.g., including a digital baseband and an analog front end module further comprises a power amplifier on a transmit path and a low noise amplifier on a receive path), and a controller 1335. Any or all of RFIC 1325 and PMIC 1330 may also include single-sided nanosheet transistors, for example in accordance with embodiments described herein.

Functionally, PMIC 1330 may perform battery power regulation, DC-to-DC conversion, etc., and so has an input coupled to battery 1315 and with an output providing a current supply to other functional modules. As further illustrated, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Notably, each of these board-level IC modules 1325, 1330, 1335 may be integrated onto separate ICs or integrated into a monolithic SoC.

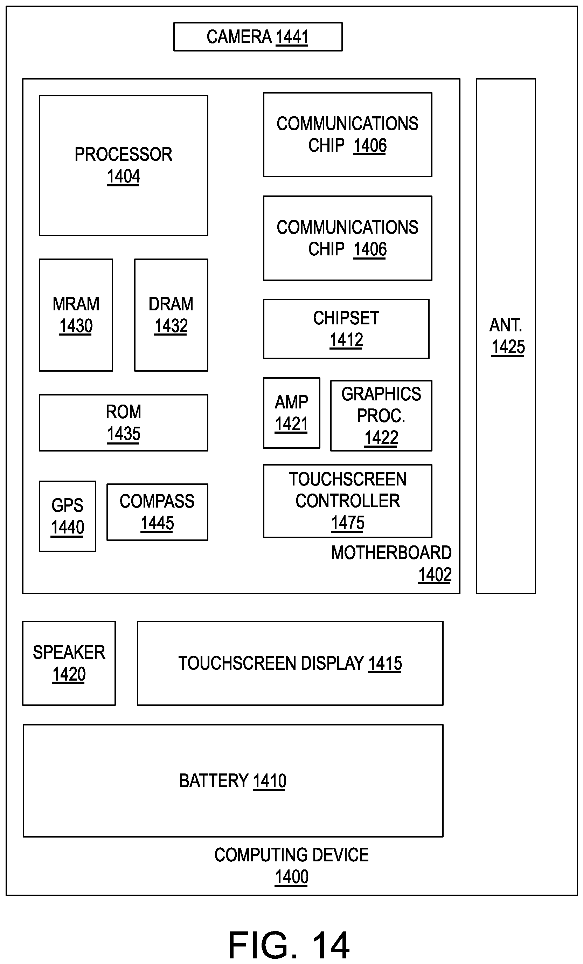

FIG. 14 is a functional block diagram of an electronic computing device 1400, in accordance with some embodiments. Computing device 1400 may be found inside platform 1305 or server machine 1306, for example. Device 1400 further includes a motherboard 1402 hosting a number of components, such as, but not limited to, a processor 1404 (e.g., an applications processor), which may further incorporate single-sided nanosheet transistors, for example in accordance with embodiments described herein. Processor 1404 may be physically and/or electrically coupled to motherboard 1402. In some examples, processor 1404 includes an integrated circuit die packaged within the processor 1404. In general, the term "processor" or "microprocessor" may refer to any device or portion of a device that processes electronic data from registers and/or memory to transform that electronic data into other electronic data that may be further stored in registers and/or memory.

In various examples, one or more communication chips 1406 may also be physically and/or electrically coupled to the motherboard 1402. In further implementations, communication chips 1406 may be part of processor 1404. Depending on its applications, computing device 1400 may include other components that may or may not be physically and electrically coupled to motherboard 1402. These other components include, but are not limited to, volatile memory (e.g., MRAM 1430, DRAM 1432), non-volatile memory (e.g., ROM 1435), flash memory, a graphics processor 1422, a digital signal processor, a crypto processor, a chipset 1412, an antenna 1425, touchscreen display 1415, touchscreen controller 1475, battery 1410, audio codec, video codec, power amplifier 1421, global positioning system (GPS) device 1440, compass 1445, accelerometer, gyroscope, audio speaker 1420, camera 1441, and mass storage device (such as hard disk drive, solid-state drive (SSD), compact disk (CD), digital versatile disk (DVD), and so forth), or the like.

Communication chips 1406 may enable wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1406 may implement any of a number of wireless standards or protocols, including but not limited to those described elsewhere herein. A first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that principles of the disclosure are not limited to the embodiments so described, but can be practiced with modification and alteration without departing from the scope of the appended claims. For example, the above embodiments may include specific combinations of features as further provided below.

In first examples, an integrated circuit (IC) structure comprises a fin comprising an upper channel semiconductor material over a lower channel semiconductor material. A source and a drain are coupled to at least one of the upper and lower channel semiconductor materials. A gate insulator is in direct contact with a first sidewall of each of the upper and lower channel semiconductor materials. A gate electrode is in contact with the gate insulator, and is adjacent to the first sidewall of each of the upper and lower channel semiconductor materials. The gate insulator and the gate electrode is also within a space between the upper and lower channel semiconductor materials. A dielectric material adjacent to both the first sidewall and a second, opposite, sidewall of each of the upper and lower channel semiconductor materials. The dielectric material is in direct contact with the second sidewall of each of the upper and lower channel semiconductor materials. The gate electrode and the gate insulator are between the dielectric material and the first sidewall of each of the upper and lower channel semiconductor materials.

In first examples an integrated circuit (IC) structure comprises a fin comprising an upper channel material over a lower channel material. A gate insulator is in direct contact with a first sidewall of the upper and lower channel materials. A gate electrode is in contact with the gate insulator and adjacent to the first sidewall of each of the upper and lower channel materials. The gate insulator and the gate electrode is also within a space between the upper and lower channel materials. A dielectric material is adjacent to the first sidewall and a second, opposite, sidewall of each of the upper and lower channel materials. The dielectric material is in direct contact with the second sidewall of each of the upper and lower channel materials. The gate electrode and the gate insulator are between the dielectric material and the first sidewall of each of the upper and lower channel materials.

In second examples, for any of the first examples the dielectric material is a first dielectric material of a first composition. The structure further comprises a second dielectric material of a second composition in direct contact with a first sidewall of a base of the fin, below the lower channel semiconductor material. The gate electrode is over the second dielectric material, and the second dielectric material is between the first dielectric material and the base of the fin.

In third examples, for any of the second examples the second dielectric material has a lateral thickness, normal from the first sidewall of the base of the fin. The first dielectric material is separated from the first sidewall of the upper and lower channel materials by no more than the lateral thickness.

In fourth examples, for any of the first through third examples the fin is a first fin and the gate electrode is a first gate electrode. The IC structure comprises a pair of second fins adjacent to the first fin. Each of the second fins comprise the upper channel material over the lower channel material. A second gate electrode is between the pair of second fins, and adjacent to a gate insulator that is in direct contact with an interior sidewall of each of the upper and lower channel materials of both second fins. The second gate electrode is between the upper and lower channel materials of both second fins, and the dielectric material is adjacent to, and in contact with, an exterior sidewall of each of the upper and lower channel materials of both second fins.

In fifth examples, for any of the fourth examples the pair of second fins are spaced apart from each other by a first distance, and one of the pair of second fins nearest to the first fin is spaced apart from the first fin by a second distance, larger than the first distance.

In sixth examples, for any of the fourth or fifth examples the dielectric material is a first dielectric material of a first composition, and the IC structure further comprises a second dielectric material of a second composition adjacent to, and in direct contact with, a first sidewall of a base of the first fin and an interior sidewall of a base of each of the second fins. Both the first and second gate electrodes are over the second dielectric material.

In seventh examples, for any of the first through sixth examples the IC structure further comprises a source and a drain. Each of the source and the drain further comprises impurity doped semiconductor material coupled to at least one of the upper or lower channel materials. Contact metal is in direct contact with a first sidewall of the impurity doped semiconductor material. The dielectric material is in direct contact with a second, opposite, sidewall of the impurity doped semiconductor material.

In eighth examples, for any of the first through seventh examples the upper and lower channel materials comprise silicon, the dielectric material silicon and oxygen, the gate electrode comprises a metal, and the gate insulator comprises a metal and oxygen.

In ninth examples a computer platform comprises electronic memory circuitry to store data, and processor circuitry coupled to the electronic memory circuitry. At least one of the electronic memory circuitry or the processor circuitry further comprises a fin comprising an upper channel material over a lower channel material, a gate insulator adjacent to, and in direct contact with, a first sidewall of each of the upper and lower channel materials, and a gate electrode in contact with the gate insulator and adjacent to the first sidewall of each of the upper and lower channel materials. The gate insulator and the gate electrode are also within a space between the upper and lower channel materials. A dielectric material is adjacent to both the first sidewall and a second, opposite, sidewall of each of the upper and lower channel materials. The dielectric material is in direct contact with the second sidewall of each of the upper and lower channel materials, and the gate electrode and the gate insulator are between the dielectric material and the first sidewall of each of the upper and lower channel materials.

In tenth examples, for any of the ninth examples a battery is coupled to at least the processor circuitry.

In eleventh examples a method of fabricating an integrated circuit (IC) structure comprises receiving a workpiece with a fin, the fin comprising an upper channel material over a lower channel material and a sacrificial material therebetween. The method comprises forming a first dielectric material adjacent to a first sidewall of the upper and lower channel materials. The method comprises forming a second dielectric material adjacent to a second sidewall of the upper and lower channel materials. The method comprises exposing the first sidewall of the upper and lower channel materials by etching at least a portion of the first dielectric material. The method comprises exposing a sidewall portion of the second dielectric material by removing the sacrificial material from between the upper and lower channel materials. The method comprises forming a gate stack in direct contact with the first sidewall of the upper and lower channel materials, and in contact with the sidewall portion of the second dielectric material.

In twelfth examples, for any of the eleventh examples forming the first dielectric material adjacent to the first sidewall of the upper and lower channel materials further comprises depositing a first dielectric material over the fin, the first dielectric material adjacent to both a first sidewall of the fin and a second, opposite, sidewall of the fin, and retaining the first dielectric material adjacent to the first sidewall of the fin while removing the first dielectric material from the second sidewall of the fin.

In thirteenth examples, for any of the twelfth examples forming the second dielectric material adjacent to the second sidewall of the upper and lower channel materials further comprises depositing the second dielectric material over the first dielectric material and adjacent to the second sidewall of the fin, and planarizing the second dielectric material with a top of the first dielectric material.

In fourteenth examples, for any of the thirteenth examples the etching of at least a portion of the first dielectric material further comprises isotropically etching through a thickness of the first dielectric material adjacent to the first sidewall of the first and second channel materials.

In fifteenth examples, for any of the eleventh through fourteenth examples the channel material comprises silicon, and removing the sacrificial material from between the upper and lower channel materials further comprises etching the sacrificial material with an etch process selective to compositions comprising more Ge than the upper and lower channel materials.

In sixteenth examples, for any of the eleventh through fifteenth examples exposing the first sidewall of the upper and lower channel materials by etching at least a portion of the first dielectric material further recessing a top surface of the first dielectric to below the lower channel material.

In seventeenth examples, for any of the eleventh through sixteenth examples forming the gate stack further comprises forming a gate insulator in direct contact with the first sidewall of both the upper and lower channel materials, and forming a gate electrode within the space between the upper and lower channel materials.

In eighteenth examples for any of the eleventh through sixteenth examples the upper and lower channel materials comprise silicon, the dielectric material silicon and oxygen, the gate electrode comprises a metal, and the gate insulator comprises a metal and oxygen.

In nineteenth examples, for any of the eighteenth examples the method further comprises forming an impurity-doped semiconductor material coupled to at least one of the upper and lower channel materials. A first sidewall of the impurity-doped semiconductor material is in direct contact with the second dielectric material, and the method comprises forming contact metal in direct contact with the impurity-doped semiconductor material.

For any of the nineteenth examples forming the contact metal further comprises: exposing a second sidewall of the impurity doped semiconductor material, and depositing the contact metal in direct contact with the second sidewall of the impurity doped semiconductor material while retaining the second dielectric material in direct contact with the first sidewall of the impurity-doped semiconductor material.

However, the above embodiments are not limited in this regard and, in various implementations, the above embodiments may include the undertaking of only a subset of such features, undertaking a different order of such features, undertaking a different combination of such features, and/or undertaking additional features than those explicitly listed. The scope of the invention should, therefore, be determined with reference to the appended claims, along with the full scope of equivalents to which such claims are entitled.

## Claims

1. An integrated circuit (IC) structure, comprising:
a fin comprising an upper channel material over a lower channel material;
a gate insulator in direct contact with a first sidewall of the upper and lower channel materials;
a gate electrode in contact with the gate insulator and adjacent to the first sidewall of each of the upper and lower channel materials, wherein the gate insulator and the gate electrode is also within a space between the upper and lower channel materials; and
a dielectric material adjacent to the first sidewall and a second, opposite, sidewall of each of the upper and lower channel materials, wherein:
the dielectric material is in direct contact with the second sidewall of each of the upper and lower channel materials; and
the gate electrode and the gate insulator are between the dielectric material and the first sidewall of each of the upper and lower channel materials.

2. The IC structure of claim 1, wherein:
the dielectric material is a first dielectric material of a first composition; and
the structure further comprises a second dielectric material of a second composition in direct contact with a first sidewall of a base of the fin, below the lower channel semiconductor material;
the gate electrode is over the second dielectric material; and
the second dielectric material is between the first dielectric material and the base of the fin.

3. The IC structure of claim 2, wherein the second dielectric material has a lateral thickness, normal from the first sidewall of the base of the fin, and wherein the first dielectric material is separated from the first sidewall of the upper and lower channel materials by no more than the lateral thickness.

4. The IC structure of any one of claims 1-3, wherein the fin is a first fin and the gate electrode is a first gate electrode, and the IC structure further comprises:
a pair of second fins adjacent to the first fin, wherein each of the second fins comprise the upper channel material over the lower channel material; and
a second gate electrode between the pair of second fins, and adjacent to a gate insulator that is in direct contact with an interior sidewall of each of the upper and lower channel materials of both second fins, wherein:
the second gate electrode is between the upper and lower channel materials of both second fins; and
the dielectric material is adjacent to, and in contact with, an exterior sidewall of each of the upper and lower channel materials of both second fins.

5. The IC structure of claim 4, wherein the pair of second fins are spaced apart from each other by a first distance, and one of the pair of second fins nearest to the first fin is spaced apart from the first fin by a second distance, larger than the first distance.

6. The IC structure of claim 4 or 5, wherein:
the dielectric material is a first dielectric material of a first composition; and
the IC structure further comprises a second dielectric material of a second composition adjacent to, and in direct contact with, a first sidewall of a base of the first fin and an interior sidewall of a base of each of the second fins; and
both the first and second gate electrodes are over the second dielectric material.

7. The IC structure of any one of claims 1-6, further comprising a source and a drain, wherein each of the source and the drain further comprises:
an impurity doped semiconductor material coupled to at least one of the upper or lower channel materials; and
a contact metal in direct contact with a first sidewall of the impurity doped semiconductor material, wherein the dielectric material is in direct contact with a second, opposite, sidewall of the impurity doped semiconductor material.

8. The IC structure of any one of claims 1-7, wherein:
the upper and lower channel materials comprise silicon;
the dielectric material silicon and oxygen;
the gate electrode comprises a metal; and
the gate insulator comprises a metal and oxygen.

9. A computer platform, comprising:
an electronic memory circuitry to store data; and
a processor circuitry coupled to the electronic memory circuitry, wherein at least one of the electronic memory circuitry or the processor circuitry further comprises:
a fin comprising an upper channel material over a lower channel material;
a gate insulator adjacent to, and in direct contact with, a first sidewall of each of the upper and lower channel materials;
a gate electrode in contact with the gate insulator and adjacent to the first sidewall of each of the upper and lower channel materials, wherein the gate insulator and the gate electrode are also within a space between the upper and lower channel materials; and
a dielectric material adjacent to both the first sidewall and a second, opposite, sidewall of each of the upper and lower channel materials, wherein;
the dielectric material is in direct contact with the second sidewall of each of the upper and lower channel materials; and
the gate electrode and the gate insulator are between the dielectric material and the first sidewall of each of the upper and lower channel materials.

10. The computer platform of claim 9, further comprising:
a battery coupled to at least the processor circuitry.

11. A method of fabricating an integrated circuit (IC) structure, comprising:
receiving a workpiece with a fin, the fin comprising an upper channel material over a lower channel material and a sacrificial material therebetween;
forming a first dielectric material adjacent to a first sidewall of the upper and lower channel materials;
forming a second dielectric material adjacent to a second sidewall of the upper and lower channel materials;
exposing the first sidewall of the upper and lower channel materials by etching at least a portion of the first dielectric material;
exposing a sidewall portion of the second dielectric material by removing the sacrificial material from between the upper and lower channel materials; and
forming a gate stack in direct contact with the first sidewall of the upper and lower channel materials, and in contact with the sidewall portion of the second dielectric material.

12. The method of claim 11, wherein forming the first dielectric material adjacent to the
first sidewall of the upper and lower channel materials further comprises:
depositing a first dielectric material over the fin, the first dielectric material adjacent to both a first sidewall of the fin and a second, opposite, sidewall of the fin; and
retaining the first dielectric material adjacent to the first sidewall of the fin while removing the first dielectric material from the second sidewall of the fin.

13. The method of claim 12, wherein forming the second dielectric material adjacent to the second sidewall of the upper and lower channel materials further comprises:
depositing the second dielectric material over the first dielectric material and adjacent to the second sidewall of the fin; and
planarizing the second dielectric material with a top of the first dielectric material.

14. The method of claim 13, wherein the etching of at least a portion of the first dielectric material further comprises isotropically etching through a thickness of the first dielectric material adjacent to the first sidewall of the first and second channel materials.

15. The method of any one of claims 11-14 wherein the channel material comprises silicon and wherein removing the sacrificial material from between the upper and lower channel materials further comprises etching the sacrificial material with an etch process selective to compositions comprising more Ge than the upper and lower channel materials.
